# DEMANDE DE BREVET EUROPEEN

(11) **EP 1 628 508 A1**
(43) Date de publication de la demande: **22.02.2006**
(21) Numéro de dépôt: 04405519.2
(22) Date de dépôt: 19.08.2004
(51) Int. Cl.: H05K 1/00, H05K 3/28, H05K 1/18

(54) **Procédé de réalisation d'un module électronique**

(71) Demandeur: Valtronic S.A., 1343 Les Charbonnières (CH)
(72) Inventeur: Zeberli, Jean-François, 1347 Le Sentier (CH); Delaloye, Serge, 1955 Chamosan (VS) (CH)
(74) Mandataire: GLN

(57) **Abrégé**

L'invention concerne un procédé de réalisation d'un module électronique. Il comprend les étapes suivantes:
- se doter d'un circuit imprimé souple (10) comportant une pluralité de bandes juxtaposées, sur chacune desquelles sont fixés plusieurs composants (11,12,13,14),
- plier ledit circuit de manière à réaliser un empilement desdits composants, et
- remplir des espaces laissés vides (17) à l'aide d'un produit durcissant et adhésif afin d'en évacuer les bulles d'air résiduelles et de rigidifier ledit empilement.

## Description

La présente invention se rapporte au domaine de la microélectronique. Elle concerne, plus particulièrement, un procédé de réalisation d'un module électronique complexe.

Dans le domaine technique de l'invention, l'une des principales préoccupations de l'homme du métier est la miniaturisation. A cet effet, une solution connue est de connecter plusieurs puces (ou chips) sur un circuit imprimé (ou PCB pour Printed Circuit Board) souple et d'enrouler ou de plier l'ensemble. Un tel module est notamment décrit dans le brevet CH 689 502.

Le module est destiné à être intégré dans un dispositif à composants multiples qui, lui aussi, doit répondre aux exigences de miniaturisation. Cela nécessite, d'une part, que les dimensions du module et sa rigidité soient parfaitement contrôlés et, d'autre part, qu'il supporte les contraintes imposées par son soudage, généralement réalisé selon le procédé connu sous le nom de "reflow soldering".

Habituellement, le problème de la rigidité mécanique du module est résolu en remplissant de résine le volume laissé libre à l'intérieur du pliage.

Or, notamment au cours de l'opération de soudage par " reflow ", les modules sont exposés à des températures élevées, de l'ordre de 230° à 240° dans le cas de soudures sans plomb. Si une bulle d'air a été emprisonnée dans la résine, de telles conditions entraînent sa dilatation et risquent de faire exploser le module.

Or, il est particulièrement difficile de garantir que la résine est exempte de bulle d'air. En effet, on comprend bien que les puces et les autres composants, tels que des CMS (Composants Montés en Surface), encombrent l'intérieur du module, empêchant la résine de s'écouler partout et offrant de nombreuses aspérités pour que de l'air s'accroche.

La présente invention a pour objet de fournir un procédé pour la réalisation d'un module électronique permettant de garantir que la résine qu'il contient ne comporte pas de bulle d'air.

De façon plus précise, l'invention concerne un procédé de réalisation d'un module électronique, comportant les principales étapes suivantes :
- se doter d'un circuit imprimé souple comportant une pluralité de bandes juxtaposées, sur chacune desquelles sont fixés plusieurs composants,
- plier ledit circuit de manière à réaliser un empilement desdits composants, et
- remplir les espaces laissés vides à l'aide d'un produit durcissant et adhésif afin d'en évacuer les bulles d'air résiduelles et de rigidifier ledit empilement.

De manière avantageuse, le procédé selon l'invention présente encore les caractéristiques suivantes, prises séparément ou en combinaison.
- Des surfaces destinées à être mises en contact sont préalablement enduites d'un produit durcissant et adhésif.
- L'étape de remplissage est réalisée, soit par injection dudit produit de manière à ce qu'il se répande dans lesdits espaces par gravité et capillarité, soit par aspiration dudit produit.
- Au cours de l'étape de remplissage, le module est maintenu dans un guide chauffant.

Le procédé selon l'invention trouve une application particulièrement intéressante au cas d'un circuit doté, à la suite les unes des autres, de quatre zones pouvant recevoir des composants. Dans ce cas, l'étape de pliage se fait, tout d'abord, en pliant la première portion sur la deuxième et la quatrième sur la troisième, puis, en pliant la première portion sur la quatrième.

L'invention sera mieux comprise à la lecture de la description qui suit, faite en référence au dessin annexé dans lequel :
- les figures 1 à 5 illustrent les différentes étapes du procédé selon l'invention,
- les figures 6 et 7 montrent des variantes de réalisation de la dernière étape du procédé, et
- la figure 8 représente une application du procédé dans une production industrielle.

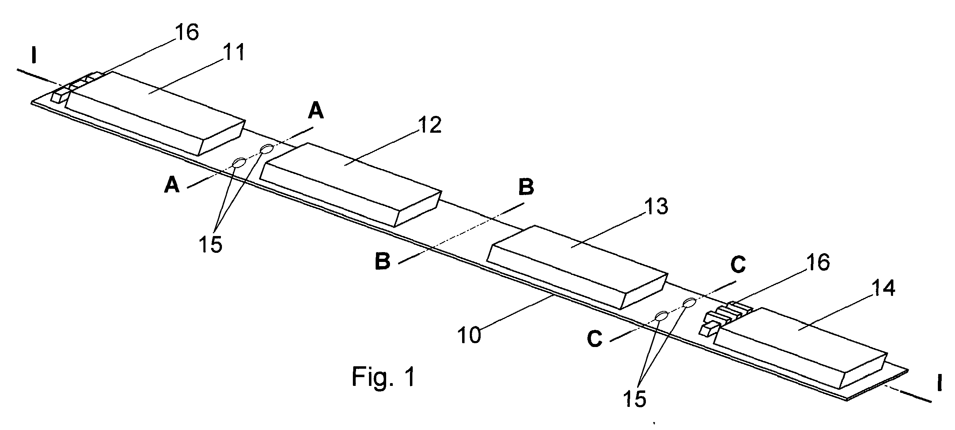

La figure 1 montre une bande de PCB 10 souple servant de base à la construction d'un module à triple pliage, réalisé par le procédé selon l'invention. Cette bande de PCB sert de support à quatre puces 11, 12, 13 et 14 préalablement fixées par les techniques connues du Flip Chip, ainsi qu'à plusieurs Composants Montés en Surface (CMS) 16. Ces composants sont alignés, parallèlement à l'axe longitudinal I-I de la bande.

Pour faciliter la compréhension du lecteur, on a représenté sur le dessin les lignes A-A, B-B et C-C selon lesquelles les pliages du PCB seront réalisés au cours du procédé, respectivement entre les puces 11 et 12, 12 et 13, et 13 et 14. Les lignes de pliage définissent quatre zones, comportant chacune un composant.

Dans l'exemple décrit, les quatre puces sont positionnées de manière à ce que, après pliage du PCB, les puces 11 et 14 soient respectivement superposées aux puces 12 et 13. On comprend donc que les puces 11 et 12 sont disposées symétriquement par rapport à la ligne de pliage A-A et que les puces 13 et 14 le sont par rapport à la ligne de pliage C-C.

Avantageusement, le PCB 10 comporte des ouvertures 15 disposées à proximité des lignes A-A et C-C, c'est-à-dire entre les puces 11 et 12, d'une part, et entre les puces 13 et 14, d'autre part. La fonction des ces ouvertures apparaîtra plus loin dans la description.

Une couche d'un produit durcissant et adhésif est, tout d'abord, appliquée sur les surfaces des puces 11 à 14. Le produit est une résine capillaire polymérisable.

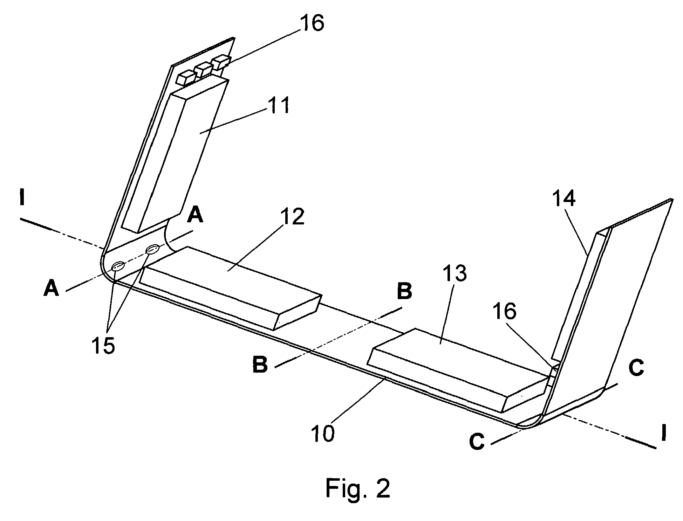

Ensuite, comme le montre la figure 2, des premier et deuxième pliages du PCB sont effectués selon les lignes A-A et C-C, au moyen de techniques connues de l'homme du métier. On notera que la quantité de résine déposée doit être adaptée de manière à occuper la totalité de l'espace interstitiel séparant deux puces en vis-à-vis, sans déborder.

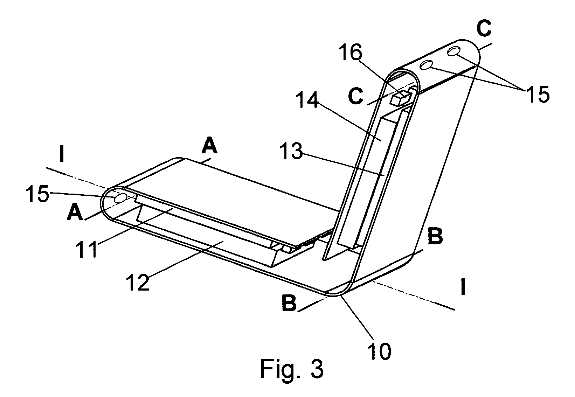

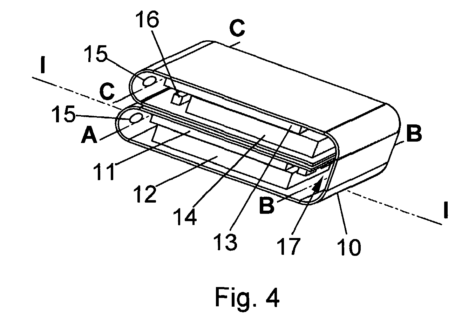

Après la prise de la résine, comme illustré par la figure 3, un troisième pliage du PCB est effectué selon la ligne B-B. Le module résultant, montré sur la figure 4, comporte plusieurs espaces vides 17.

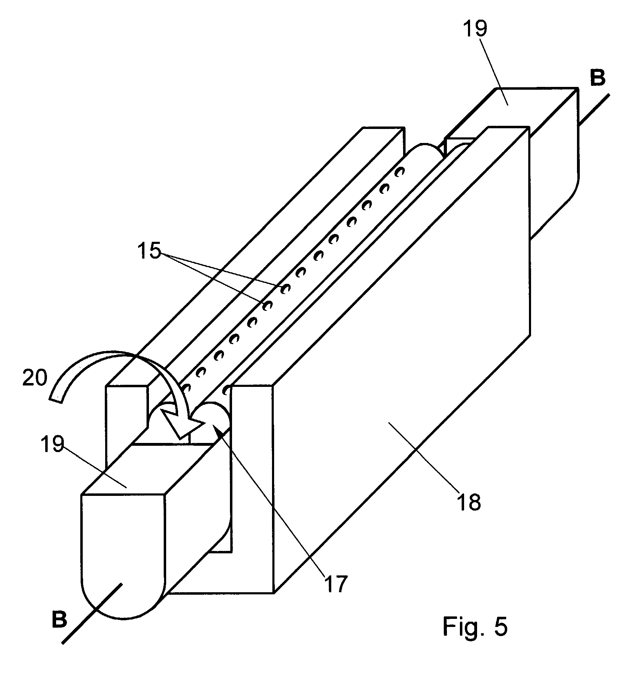

L'opération suivante est illustrée sur la figure 5. Le module est inséré dans un guide 18, en forme de U et de dimension adaptée, qui est destiné à le maintenir dans sa position et à contrôler ses dimensions. De préférence, le guide 18 est chauffant et le pli effectué selon la ligne B-B est disposé du côté de son fond.

Des bouchons 19 en mousse de polymère sont placés sur les deux côtés ouverts du module. Puis, une résine polymérisable de type capillaire, déjà mentionnée, est injectée dans les espaces vides 17 par un orifice 20 ménagé à l'une des extrémités supérieures du module, jusqu'à ce qu'elle atteigne l'autre extrémité. De par ses propriétés de mouillabilité, la résine se répand dans le module par gravité et, pour les petits volumes, par capillarité. En chauffant le module au moyen du guide 18, la fluidité et la répartition de la résine sont sensiblement améliorées. Il n'est ainsi pas nécessaire de réaliser l'injection sous forte pression. Grâce à cette opération, la totalité de l'air emprisonné à l'intérieur du module s'échappe par les ouvertures 15.

Après le remplissage, le module, toujours maintenu dans son guide 18, est mis à étuver, typiquement à 125 °C pendant 60 minutes, de manière à faire prendre la résine. Il ne restera plus, alors, qu'à retirer les bouchons 19 et éliminer le guide 18 pour obtenir un module de dimensions parfaitement contrôlées et totalement exempt de bulle d'air.

Il peut être avantageux, avant le troisième pliage, d'appliquer une couche de résine sur les parties du PCB que ce pliage amène en vis-à-vis, c'est-à-dire de l'autre côté des parties sur lesquelles sont fixées les puces 11 et 14.

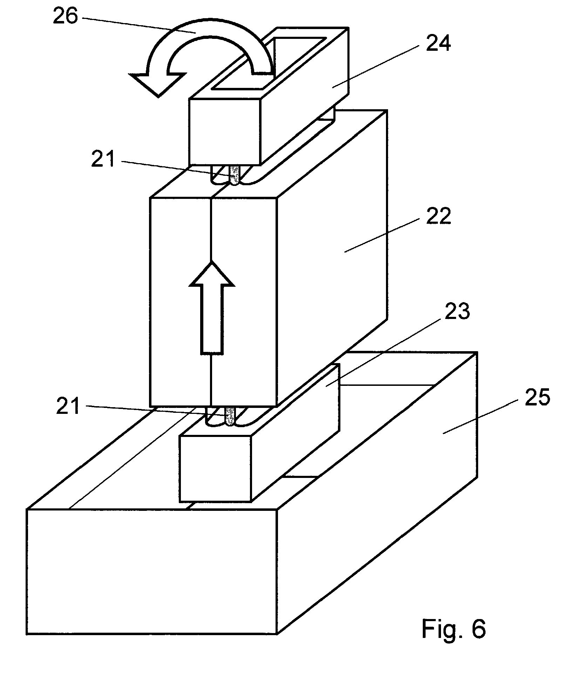

Selon une variante de mise en oeuvre du procédé selon l'invention, illustrée par la figure 6, le PCB ne comporte plus les ouvertures 15 et les premières étapes sont semblables à celles décrites ci-dessus, jusqu'avant le remplissage.

C'est cette étape de remplissage qui varie. Un joint d'étanchéité 21 est disposé le long de l'ouverture qui sépare les lignes de pliage A-A et C-C. Le module, ainsi préparé, est placé dans un guide de maintien 22, de préférence chauffant, qui l'enserre complètement.

Le tout étant disposé de manière à ce que les axes de pliages soient verticaux, les extrémités inférieure 23 et supérieure 24 du module sont alors respectivement reliées, de manière étanche et par des tuyaux, à un réservoir 25 de résine polymérisable capillaire et à un circuit d'aspiration 26.

Par une légère aspiration combinée à un chauffage du guide 22, la résine se répand à l'intérieur du module, du bas vers le haut. Les bulles d'air prisonnières remontent ainsi avec le produit adhésif et sont finalement éliminées.

Pour éviter que la résine s'écoule après l'arrêt de l'aspiration, le tuyau relié à l'extrémité inférieure 23 du module est pincé et l'ensemble est ensuite mis à étuver de manière à faire prendre la résine. Après étuvage, les tuyaux sont déconnectés et le module est sorti du guide 22. Il est alors prêt à l'emploi.

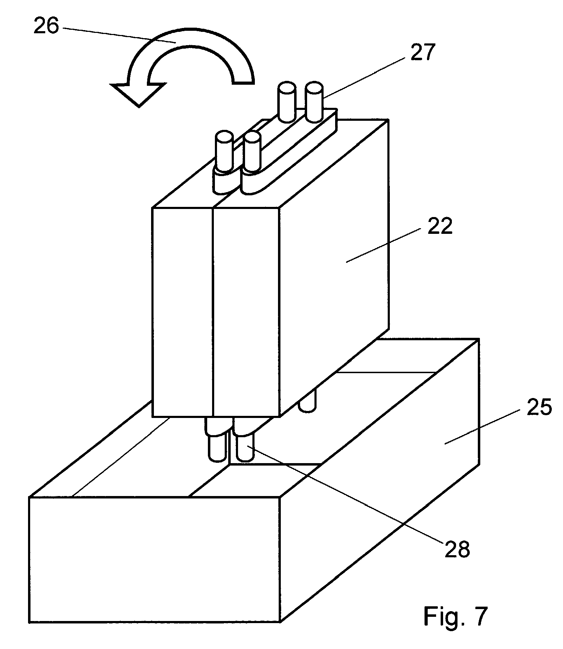

Une autre variante de mise en oeuvre du procédé selon l'invention, très proche de la solution précédente, est illustrée par la figure 7. Le remplissage du module n'est pas assuré par des tuyaux, mais par une pluralité de microtubes, 28 et 27 reliés de manière étanche lors des pliages successifs aux extrémités inférieure et supérieure du module. Les microtubes inférieurs 28 sont plongés dans un réservoir 25 de résine polymérisable et les microtubes supérieurs 27 sont reliés à un circuit d'aspiration 26.

Comme avec les tuyaux, la résine se répand à l'intérieur du module, du bas vers le haut, au moyen d'une légère aspiration combinée à un chauffage du guide 22. Les bulles d'air prisonnières remontent ainsi avec la colle et sont finalement éliminées.

Pour éviter que la résine s'écoule après l'arrêt de l'aspiration, les microtubes 28 reliés à l'extrémité inférieure du module sont pincés. L'ensemble est ensuite mis à étuver de manière à faire prendre la résine. Après étuvage, les tuyaux sont déconnectés et le module est sorti du guide 22. Il est alors prêt à l'emploi.

Quel que soit le mode de réalisation utilisé, le module obtenu est de forme parfaitement contrôlée et totalement exempt de bulle d'air. Il peut être inséré dans le dispositif auquel il est destiné, sa connexion électrique se faisant à l'aide de zones de contact (non représentées) ménagées sur l'une ou les faces externes du PCB.

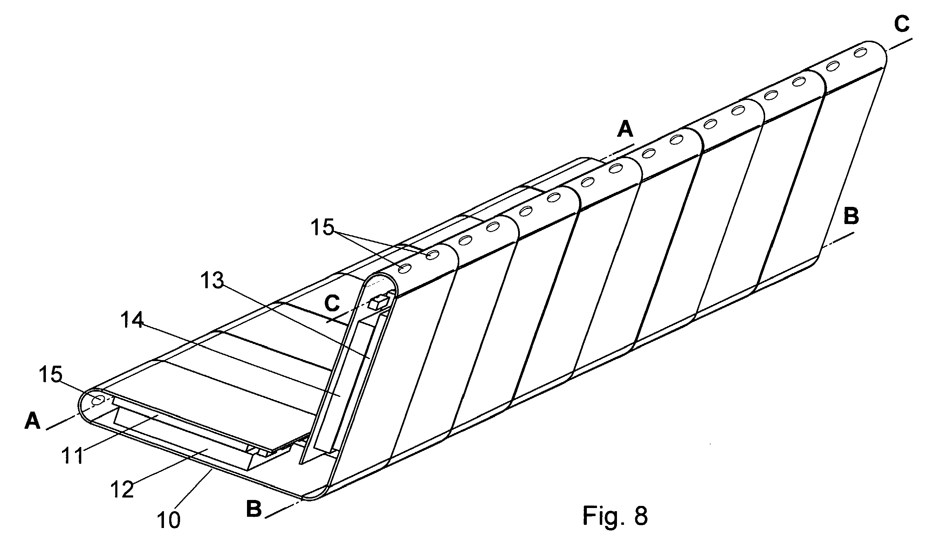

La description ci-dessus n'est qu'un exemple ayant pour but d'expliciter l'invention. Il va de soi que, pour une production industrielle, de tels modules électroniques ne sont pas fabriqués à l'unité, mais par séries, comme le montre la figure 8. Cela signifie que le PCB est, en fait, formé d'une pluralité de bandes juxtaposées et dotées de composants électroniques. Les étapes de collage, de pliage et de remplissage sont effectuées sur l'ensemble, le remplissage se faisant d'une extrémité à l'autre. Les modules sont finalement individualisés par sciage après l'ultime étuvage.

Bien entendu, l'invention peut être adaptée à des modules pliés de différentes manières et comportant plus ou moins de puces de tailles variées et, éventuellement, disposées non symétriquement. L'essentiel est toujours d'encoller, avant pliage, les parties qui seront en vis-à-vis d'autres et donc difficiles d'accès pour la résine.

## Revendications

1. Procédé de réalisation d'un module électronique, **caractérisé en ce qu'**il comporte les étapes suivantes :
- se doter d'un circuit imprimé souple (10) comportant une pluralité de bandes juxtaposées, sur chacune desquelles sont fixés plusieurs composants (11, 12, 13, 14),
- plier ledit circuit de manière à réaliser un empilement desdits composants, et
- remplir les espaces laissés vides (17) à l'aide d'un produit durcissant et adhésif afin d'en évacuer les bulles d'air résiduelles et de rigidifier ledit empilement.

2. Procédé selon la revendication 1, **caractérisé en ce que** des surfaces destinées à être mises en contact sont préalablement enduites d'un produit durcissant et adhésif.

3. Procédé selon l'une des revendications 1 et 2, **caractérisé en ce que** l'étape de remplissage est réalisée par injection dudit produit de manière à ce qu'il se répande dans lesdits espaces (17) par gravité et capillarité.

4. Procédé selon l'une des revendications 1 et 2, **caractérisé en ce que** l'étape de remplissage est réalisée par aspiration dudit produit dans lesdits espaces (17).

5. Procédé selon l'une des revendications 1 à 4, **caractérisé en ce que**, au cours de l'étape de remplissage, le module est maintenu dans un guide chauffant (18, 22).

6. Procédé selon l'une des revendications 1 à 5, appliqué à un circuit imprimé comportant, à la suite les unes des autres, des première, deuxième, troisième et quatrième portions pouvant recevoir des composants, **caractérisé en ce que** l'étape de pliage se fait :
- tout d'abord, en pliant la première portion sur la deuxième et la quatrième sur la troisième,
- puis, en pliant la première portion sur la quatrième.
